# EUROPÄISCHE PATENTSCHRIFT

(11) **EP 0 626 098 B1**
(45) Veröffentlichungstag und Bekanntmachung des Hinweises auf die Patenterteilung: **05.06.1996**
(21) Anmeldenummer: 93902067.3
(22) Anmeldetag: 01.02.1993
(51) Int. Cl.: H01L 21/82, H01L 27/108

(54) **VERFAHREN ZUR HERSTELLUNG EINES KONTAKTES ZU EINER GRABENKONDENSATORELEKTRODE**
METHOD OF PRODUCING A CONTACT WITH A TRENCH-CONDENSER ELECTRODE
PROCEDE DE REALISATION D'UN CONTACT AVEC UNE ELECTRODE DE CONDENSATEUR DE TRANCHEE

(30) Priorität: 13.02.1992 DE 4204298
(43) Veröffentlichungstag der Anmeldung: 30.11.1994
(73) Patentinhaber: SIEMENS AKTIENGESELLSCHAFT, D-80333 München (DE)
(72) Erfinder: RÖSNER, Wolfgang, Dr., D-81739 München (DE); HOFMANN, Franz, Dr., D-80995 München (DE); RISCH, Lothar, Dr., D-85579 Neubiberg (DE)
(86) Internationale Anmeldenummer: DE9300078
(87) Internationale Veröffentlichungsnummer: WO9316490

(56) Entgegenhaltungen:
- US-A- 4 967 248
- PATENT ABSTRACTS OF JAPAN vol. 8, no. 167 (E-258)(1604) 2. August 1984&JP-A-59 0630757
- ARCHIV FUR ELEKTRONIK UND UBERTRAGUNGSTECHNIK Bd. 44, Nr. 3, Mai 1990, STUTTGART DE Seiten 200 - 207 W. M]LLER ET D. KRANZER 'Technologies for Megabit DRAMs'
- PATENT ABSTRACTS OF JAPAN vol. 13, no. 78 (E-718)(3426) 22. Februar 1989&JP-A-63 260 163
- PATENT ABSTRACTS OF JAPAN vol. 12, no. 118 (E-600)(2965) 13. April 1988&JP-A-62 247 560
- PATENT ABSTRACTS OF JAPAN vol. 13, no. 541 (E-854)(38889) 5. Dezember 1989&JP-A-12 22 472

## Beschreibung

Für den Entwurf von 16 M- und 64 M-DRAM-Schaltungen werden Konzepte für Speicherzellen benötigt, die einen geringen Platzbedarf haben und sich in hoher Packungsdichte in einem Substrat anordnen lassen. Ein solches Konzept für eine Speicherzelle ist als ISTT-DRAM-Zelle (Isolated Stack in Trench) und als BSCC (Buried stacked capacitor cell) bekannt. Diese Speicherzelle umfaßt einen Transistor und einen Kondensator. Der Kondensator ist mit beiden Kondensatorelektroden und dem Dielektrikum in einem Graben angeordnet, wobei der Kondensator gegen das Substrat durch eine an der Grabenoberfläche angeordnete Oxidschicht isoliert ist (s. z. B. J. Dietl et al, ESSDERC 90, Seite 465 bis 468).

In diesem Zellkonzept ist es erforderlich, einen elektrischen Kontakt zwischen dem Source/Drain-Gebiet des Transistors und der im Graben angeordneten, gegen das Substrat isolierten Kondensatorelektrode, auf der die der Information entsprechende Ladung gespeichert ist, herzustellen.

Aus der Literatur (s. J. Dietl, ESSDERC 90, Seite 465 bis 468) sind zwei Möglichkeiten zur Herstellung des Kontaktes bekannt:

Nach der Ätzung des Grabens wird die Oberfläche des Grabens mit einer SiO₂-Schicht versehen. Anschließend wird der Graben mit Fotolack aufgefüllt. Die Ausdehnung des Kontaktes an der dem Transistor zugewandten Flanke des Grabens wird durch Rückbelichtung des Fotolacks bis zu der vorgegebenen Tiefe definiert. Diese Belichtung des Fotolacks in der Tiefe ist nur schlecht reproduzierbar. Es treten dabei Schwankungen um 1 µm auf. Deshalb ist es mit diesem Verfahren nicht möglich, den Kontakt nur zum späteren Source/Drain-Gebiet hin zu öffnen. Es kommt zwangsläufig auch zu einer Kontaktöffnung zu unter dem Source/Drain-Gebiet angeordneten Teilen des Substrats. Dieses führt zur Punch-through und Leckströmen.

Alternativ wird zunächst eine flache Grabenätzung vorgenommen. An der dem Source/Drain-Gebiet benachbarten Flanke wird ein Si₃N₄-Spacer gebildet. Es folgt eine weitere Grabenätzung, bei der die endgültige Tiefe des Grabens erreicht wird. Anschließend wird die Oberfläche des Grabens mit einer SiO₂- Schicht versehen. Durch Ablösen des Si₃N₄-Spacers wird der Kontakt zum Source/Drain-Gebiet geöffnet. Die Tiefe des Kontaktes wird über die Tiefe der flachen Ätzung eingestellt. Bei der flachen Ätzung muß darauf geachtet werden, daß auf der dem Source/Drain-Gebiet abgewandten Seite des entstehenden Grabens, an der die Speicherzelle durch einen Feldoxidbereich von benachbarten, aktiven Bereichen isoliert ist, das Substrat nicht freigelegt wird. Anderenfalls entsteht auch auf dieser Seite ein Kontakt zum Substrat, der die Isolation zwischen den Zellen beeinträchtigt.

Bei beiden bekannten Verfahren ist neben der Fototechnik für die Grabenstrukturierung eine weitere Fototechnik für die Definition der Lage des Kontakts erforderlich.

Der Erfindung liegt daher das Problem zugrunde, ein Verfahren zur Herstellung eines Kontaktes zwischen einer in einem Graben angeordneten Kondensatorelektrode und einem außerhalb des Grabens angeordneten Source/Drain-Gebiet eines MOS-Transistors anzugeben, bei dem die Tiefe des Kontaktes gut kontrollierbar ist und bei dem gleichzeitig eine sichere Isolation zwischen benachbarten aktiven Gebieten sichergestellt ist.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird die Tiefe des Kontaktes über die erste Tiefe der ersten Ätzung eingestellt.

Diese erste Ätzung erfolgt unter Verwendung der Grabenmaske und des freiliegenden Teils des Feldoxidbereichs als Ätzmaske. Erst nach der Bildung des Si₃N₄-Spacers an der bei der ersten Ätzung freigelegten Flanke des Substrats, an der der Kontakt entsteht, wird der freiliegende Teil des Feldoxids entfernt und der Graben durch eine weitere Ätzung fertiggestellt. Auf diese Weise kann an dem Feldoxidbereich benachbarten Seiten des Grabens erst nach der Herstellung des Si₃N₄-Spacers Substratmaterial freigelegt werden. Dieses wird dann bei der Bildung der isolierenden SiO₂-Schicht an der Oberfläche des Grabens mit SiO₂ versehen.

In dem erfindungsgemäßen Verfahren kann daher die Tiefe des Kontaktes unabhängig von der Dicke des Feldoxidbereichs eingestellt werden. Ferner ist eine gute Isolation des Grabens gegen benachbarte aktive Gebiete im Substrat sichergestellt. Die erste Ätzung erfolgt selbstjustiert zum Feldoxidbereich, wodurch eine Fototechnik zur Kontaktdefinition entfällt.

Im folgenden wird die Erfindung anhand eines Ausführungsbeispiels und der Figuren näher erläutert.
- Fig. 1: zeigt die Herstellung der Grabenmaske.
- Fig. 2: zeigt die Struktur nach der ersten Ätzung.
- Fig. 3: zeigt die Herstellung von Si₃N₄-Spacern.
- Fig. 4: zeigt die Struktur nach dem Entfernen der freiliegenden Teile des Feldoxidbereichs.
- Fig. 5: zeigt die Struktur nach der Fertigstellung des Grabens.
- Fig. 6: zeigt die Struktur nach der Herstellung der isolierenden SiO₂-Schicht im Graben.
- Fig. 7: zeigt die Struktur nach der Öffnung des Kontaktes und der Herstellung der Kondensatorelektrode.

Die Figuren sind nicht maßstabsgetreu gezeichnet.

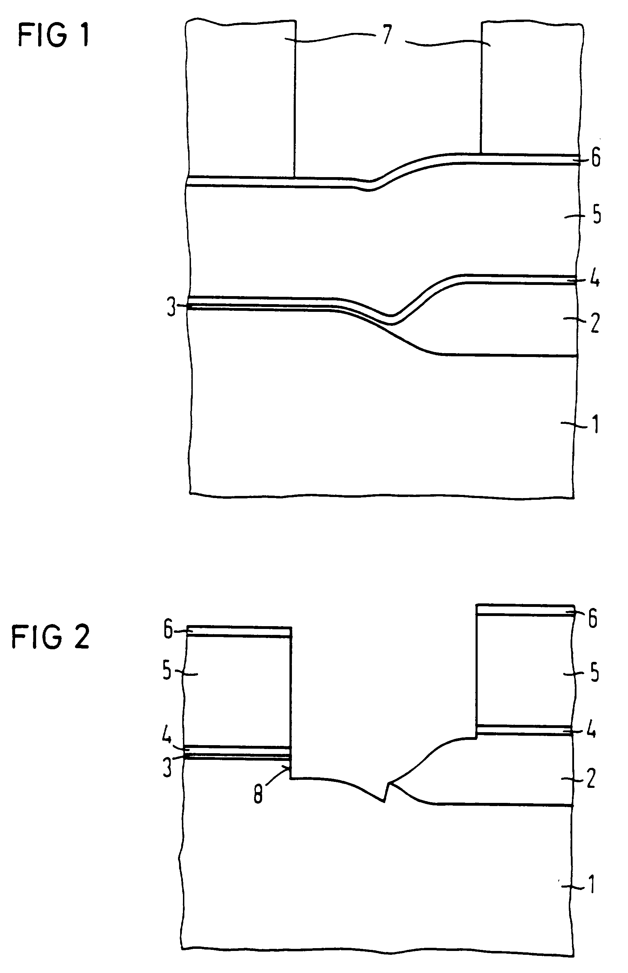

In einem Substrat 1 aus z. B. p-dotiertem, einkristallinem Silizium werden in bekannter Weise Wannen zur Aufnahme von MOS-Transistoren hergestellt (nicht dargestellt). In einem LOCOS-Prozeß (nicht im einzelnen dargestellt) wird mindestens ein Feldoxidbereich 2 hergestellt (s. Fig. 1). Der Feldoxidbereich 2 dient zur Isolation zwischen benachbarten, aktiven Gebieten im Substrat 1.

Zur Herstellung einer Maske für eine Grabenätzung wird ganzflächig z. B. durch thermische Oxidation eine erste SiO₂- Schicht 3 hergestellt. Die erste SiO₂-Schicht 3 wird in einer Dicke von z. B. 24 nm hergestellt. Auf der ersten SiO₂-Schicht 3 wird eine Si₃N₄-Schicht 4 in einer Dicke von z. B. 40 nm abgeschieden. Auf der Si₃N₄-Schicht 4 wird eine zweite SiO₂- Schicht 5 durch Zersetzung von Si(OC₂H₅)₄ (TEOS) in einer Dicke von z. B. 600 nm hergestellt. Auf der zweiten SiO₂- Schicht 5 wird eine Polysiliziumschicht 6 in einer Dicke von z. B. 50 nm hergestellt.

An der Oberfläche der Polysiliziumschicht 6 wird aus einer Fotolackschicht durch Belichten und Entwickeln eine Fotolackmaske 7 hergestellt. Die Fotolackmaske 7 definiert den Ort für eine Grabenätzung. Die Fotolackmaske läßt den Feldoxidbereich 2 auf der Seite, an der später das Source/Drain-Gebiet entsteht, teilweise unbedeckt. Die Öffnung der Fotolackmaske 7 reicht in das Gebiet des Substrats 1 hinein, das von dem Feldoxidbereich 2 unbedeckt ist und in dem später das Source/Drain-Gebiet für den Transistor hergestellt wird.

In einem Trockenätzprozeß, z. B. mit Cl₂, He, wird die Polysiliziumschicht 6 unter Verwendung der Fotolackmaske 7 als Ätzmaske strukturiert. Dabei wird die Oberfläche der zweiten SiO₂-Schicht 5 freigelegt.

In einem Trockenätzprozeß, z. B. mit CHF₃, O₂, wobei die Selektivität (TEOS: Nitrid) auf 1.8:1 eingestellt wird, wird die zweite SiO₂-Schicht 5 unter Verwendung der Fotolackmaske 7 als Ätzmaske strukturiert, wobei die Oberfläche der Si₃N₄-Schicht 4 freigelegt wird.

In einem Trockenätzprozeß, z. B. mit CHF₃, O₂, wobei die Selektivität (Nitrid: thermisches Oxid) auf 3,2:1 eingestellt wird, wird die Si₃N₄-Schicht 4 unter Verwendung der Fotolackmaske 7 als Ätzmaske strukturiert. In dem selben Trockenätzprozeß wird die erste SiO₂-Schicht 3 strukturiert, wobei die Fotolackmaske 7 als Ätzmaske wirkt. Dabei wird im freiliegenden Teil des Feldoxidbereichs 2 die Oberfläche leicht abgetragen. Die Oberfläche des Substrats 1 wird jedoch nur außerhalb des Feldoxidbereichs 2 freigelegt.

In einem Trockenätzprozeß, z. B. mit HBr, He, O₂, NF₃, wird eine erste Ätzung in das Substrat 1 zur Herstellung des Grabens vorgenommen. Die erste Ätzung erfolgt z. B. in einer ersten Tiefe von 100 nm. Bei der ersten Ätzung wirken die Fotolackmaske 7 und der freiliegende Bereich des Feldoxidbereichs 2 gemeinsam als Ätzmaske. Das Substrat 1 wird daher bei der ersten Ätzung nur seitlich des Feldoxidbereichs 2 angegriffen (s. Fig. 2). Dabei wird auf der dem Feldoxid 2 abgewandten Seite eine senkrechte Substratflanke 8 freigelegt. Die erste Tiefe der ersten Ätzung bestimmt die Ausdehnung der senkrechten Substratflanke 8 in der Richtung senkrecht zur Substratoberfläche. An der bei der ersten Ätzung freigelegten senkrechten Substratflanke 8 wird im folgenden ein Kontakt zwischen einer in einem Graben angeordneten Kondensatorelektrode und einem außerhalb des Grabens angeordneten Source/Drain-Gebiet eines MOS-Transistors gebildet.

Nach der ersten Ätzung wird die Fotolackmaske 7 entfernt.

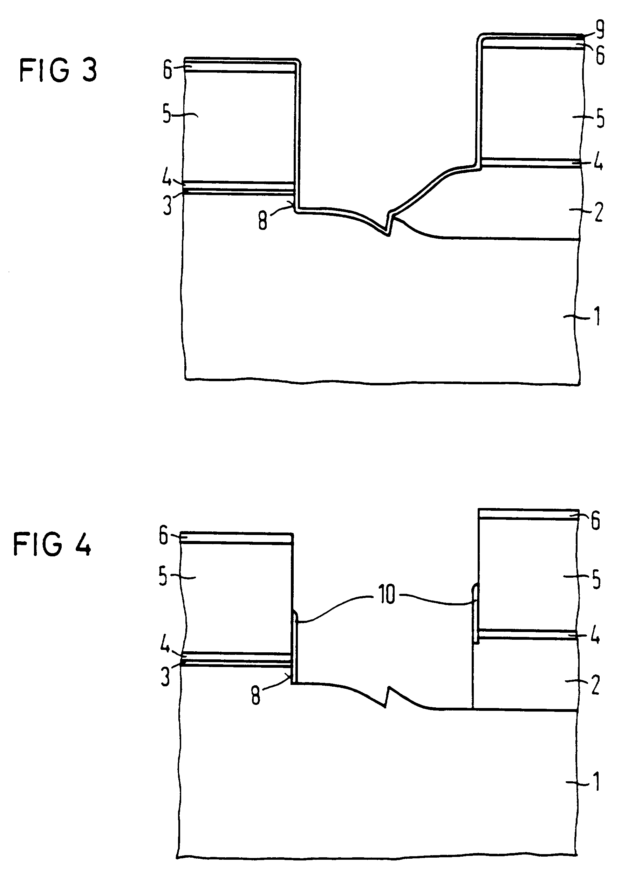

Es folgt die Abscheidung einer konformen Si₃N₄-Schicht 9. Die konforme Si₃N₄-Schicht 9 wird in einer Dicke von z. B. 40 nm ganzflächig abgeschieden (s. Fig. 3).

In einem Trockenätzprozeß, z. B. mit CHF₃, O₂, werden die nicht senkrechten Teile der konformen Si₃N₄-Schicht 9 entfernt.

Unter Verwendung der Polysiliziumschicht 6 als Maske wird in dem selben Trockenätzprozeß der freiliegende Teil des Feldoxidbereichs 2 abgeätzt. An senkrechten Flanken, unter anderem auch an der freigelegten senkrechten Substratflanke 8, bilden sich dabei Si₃N₄-Spacer 10, die die bei der ersten Ätzung freigelegte senkrechte Substratflanke 8, die an der vom Feldoxidbereich 2 abgewandten Seite liegt, sicher bedecken.

Im nächsten Schritt erfolgt eine Ätzung in das Substrat 1 zur Erzeugung eines Grabens 11. Dabei wirkt die strukturierte zweite SiO₂-Schicht 5 als Ätzmaske. Die Ätzung erfolgt anisotrop z. B. mit HBr, He, O₂, NF₃. Der Graben 11 wird in einer Tiefe von z. B. 5 µm hergestellt. Dabei wird die strukturierte Polysiliziumschicht 6 an der Oberfläche der zweiten SiO₂-Schicht 5 entfernt.

Der verbliebene Rest der als Ätzmaske verwendeten, zweiten SiO₂-Schicht 5 wird z. B. durch Ätzung mit trockenem HF-Gas entfernt.

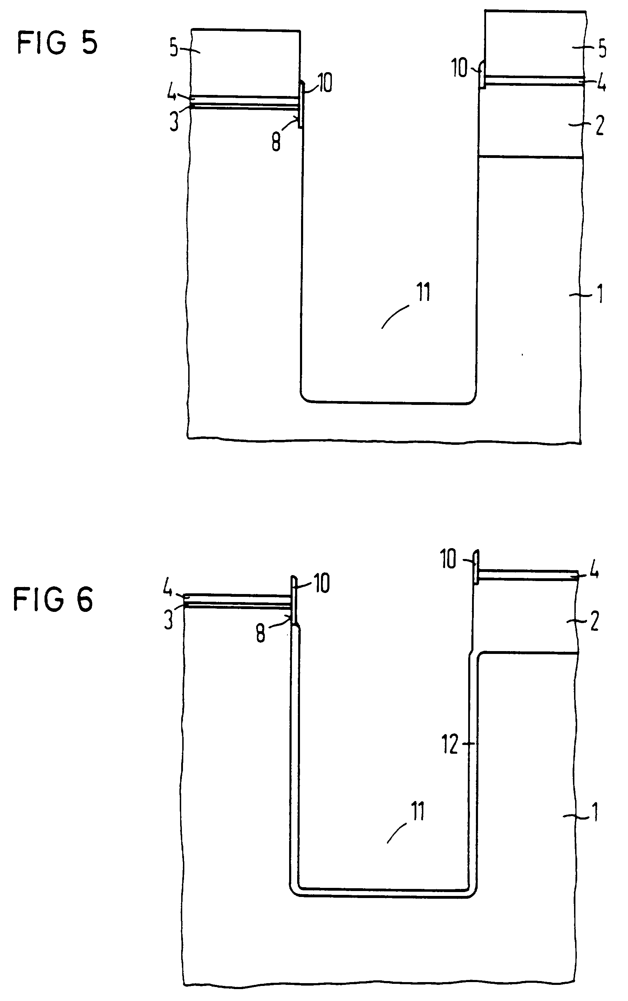

Durch z. B. thermische Oxidation wird an der Oberfläche des Grabens 11 eine dritte SiO₂-Schicht 12 in einer Dicke von z. B. 40 nm hergestellt (s. Fig. 6). Die dritte SiO₂-Schicht 12 isoliert das innere des Grabens bis auf den Bereich der senkrechten Substratflanke 8, die mit dem Si₃N₄-Spacer 10 bedeckt ist, vom Substrat 1.

Durch naßchemisches Ätzen, z. B. mit 155°C warmer H₃PO₄, werden die verbleibenden Si₃N₄-Spacer 10 und die strukturierte Si₃N₄-Schicht 4 entfernt. Dabei wird die senkrechte Substratflanke 8 freigelegt.

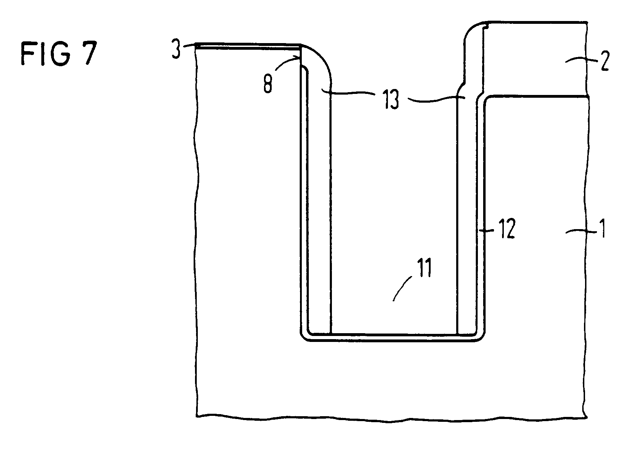

Durch konformes Abscheiden und anschließendes anisotropes Rückätzen einer Polysiliziumschicht wird eine die Flanken des Grabens 11 bedeckende Kondensatorelektrode 13 fertiggestellt (s. Fig. 7).

Im Bereich der senkrechten Substratflanke 8, die bei der Oxidation der Oberfläche des Grabens 11 mit einem Si₃N₄-Spacer 10 bedeckt war, steht die Kondensatorelektrode 13 mit dem Substrat 1 in Verbindung. Im folgenden wird in diesem Bereich des Substrats 1 ein Source/Drain-Gebiet für einen MOS-Transistor gebildet. Die Kondensatorelektrode 13 ist außerhalb der senkrechten Substratflanke 8 durch die dritte SiO₂-Schicht 12 gegen das Substrat 1 isoliert.

## Patentansprüche

1. Verfahren zur Herstellung eines Kontaktes zwischen einer in einem Graben angeordneten Kondensatorelektrode und einem außerhalb des Grabens angeordneten Source/Drain-Gebiet eines MOS-Transistors
- bei dem in einem Substrat (1) mindestens ein Feldoxidbereich (2) seitlich des zuhünftigen Source/Drain-Gebietes zur Isolation gegen benachbarte, aktive Bereiche im Substrat (1) gebildet wird,
- bei dem eine Grabenmaske erzeugt wird, die den Ort des Grabens seitlich des zuhünftigen Source/Drain-Gebietes auf der dem zuhünftigen Source/Drain-Gebiet zugewandten Seite des Feldoxidbereichs (2) so definiert, daß der Graben zwischen dem zuhünftigen Source Drain-Gebiet und dem Feldoxidbereich (2) angeordnet wird,
- bei dem die Grabenmaske den Feldoxidbereich (2) auf der dem zuhünftigen Source/Drain-Gebiet zugewandten Seite teilweise unbedeckt läßt,
- bei dem an der Oberfläche der Grabenmaske Photolack angeordnet ist,
- bei dem eine erste Ätzung zur Herstellung des Grabens in einer ersten Tiefe in das Substrat (1) erfolgt, die das Substrat selektiv zu Photolack und dem Feldoxidbereich (2) angreift, so daß die mit Photolack bedeckte Grabenmaske und der freiliegende Teil des Feldoxidbereichs (2) als Ätzmaske wirken, wobei an der dem zuhünftigen Source/Drain-Gebiet zugewandten Seite des Grabens (11) eine senkrechte Substratflanke (8) freigelegt wird,
- bei dem nach Entfernen des Photolacks eine konforme Si₃N₄-Schicht (9) abgeschieden wird,
- bei dem durch anisotropes Ätzen aus der konformen Si₃N₄-Schicht (9) an senkrechten Flanken Si₃N₄-Spacer (10) gebildet werden und der freiliegende Teil des Feldoxidbereichs selektiv zur Grabenmaske abgeätzt wird,
- bei der eine zweite Ätzung in einer zweiten Tiefe in das Substrat (1) erfolgt, wobei der Querschnitt des Grabens (11) durch die Grabenmaske und die Tiefe des Grabens (11) durch die zweite Tiefe definiert werden,
- bei dem die Oberfläche des Grabens (11) mit einer SiO₂-Schicht (12) versehen wird,
- bei dem die Si₃N₄-Spacer (10) selektiv zu SiO₂ und Si entfernt werden,
- bei dem die Kondensatorelektrode (13) im Graben (11) so erzeugt wird, daß sie mindestens die bei der Ätzung freigelegte, senkrechte Substratflanke (8) bedeckt,
- bei dem auf der dem Feldoxidbereich (2) abgewandten Seite des Grabens (11) ein an die Kondensatorelektrode (13) angrenzendes Source/Drain-Gebiet erzeugt wird.

2. Verfahren nach Anspruch 1,
bei dem der Feldoxidbereich (2) in einem OCOS-Prozeß hergestellt wird.

3. Verfahren nach Anspruch 1 oder 2,
- bei dem zur Herstellung der Grabenmaske auf das mit dem Feldoxidbereich (2) versehene Substrat (1) eine erste SiO₂-Schicht (3) aufgebracht wird, die dünner ist als der Feldoxidbereich (2),
- bei dem auf die erste SiO₂-Schicht (3) eine Si₃N₄-Schicht (4) aufgebracht wird,
- bei dem auf die Si₃N₄-Schicht (4) eine zweite SiO₂-Schicht (5) aufgebracht wird,
- bei dem auf die zweite SiO₂-Schicht (5) eine Polysiliziumschicht (6) aufgebracht wird,
- bei dem auf der Polysiliziumschicht (6) eine Fotolackmaske (7) hergestellt wird, die den Querschnitt des Grabens parallel zur Substratoberfläche definiert,
- bei dem die Polysiliziumschicht (6), die zweite SiO₂-Schicht (5), die Si₃N₄-Schicht (4) und die erste SiO₂-Schicht (3) jeweils in einem anisotropen Trockenätzschritt unter Verwendung der Fotolackmaske (7) als Ätzmaske strukturiert werden, so daß die Oberfläche des Substrat (1) seitlich des Feldoxidbereichs (2) freigelegt wird,
- bei dem die Fotolackmaske (7) nach der ersten Ätzung zur Herstellung des Grabens (11) entfernt wird.

4. Verfahren nach Anspruch 3,
bei dem die erste SiO₂-Schicht (3) durch thermische Oxidation der Oberfläche des Substrats (1) hergestellt wird und bei der die zweite SiO₂-Schicht (5) durch CVD-Abscheidung nach Zersetzung von Si(OC₂H₅)₄ (TEOS) hergestellt wird.

5. Verfahren nach Anspruch 4,
bei dem die erste SiO₂-Schicht (3) in einer Dicke zwischen 10 nm und 40 nm, die Si₃N₄-Schicht (4) in einer Dicke zwischen 20 nm und 60 nm die zweite SiO₂-Schicht (5) in einer Dicke Schicht (5) in einer Dicke zwischen 200 nm und 1000 nm und die Polysiliziumschicht (6) in einer Dicke zwischen 20 nm und 100 nm hergestellt werden.

6. Verfahren nach einem der Ansprüche 1 bis 5,
bei dem die konforme Si₃N₄-Schicht (9) zur Bildung der Si₃N₄-Spacer (10) in einer Dicke zwischen 10 nm und 100 nm abgeschieden wird.

7. Verfahren nach einem der Ansprüche 1 bis 6,
bei dem die Si₃N₄-Spacer (10) durch naßchemisches Ätzen entfernt werden.

8. Verfahren nach einem der Ansprüche 1 bis 7,
bei dem die erste Tiefe einen Wert zwischen 30 nm und 300 nm und die zweite Tiefe einen Wert zwischen 2 µm und 20 µm annimmt.

## Claims

1. Process for making a contact between a capacitor electrode disposed in a trench and an MOS transistor source/drain region disposed outside the trench
- in which at least one field-oxide region (2) is formed in a substrate (1) to the side of the future source/drain region as insulation from adjacent active regions in the substrate (1),
- in which a trench mask is produced which defines the position of the trench to the side of the future source/drain region on the side of the field-oxide region (2) adjacent to the future source/drain region such that the trench is arranged between the future source/drain region and the field-oxide region (2),
- in which the trench mask leaves the field-oxide region (2) partially uncovered on the side adjacent to the future source/drain region,
- in which a photoresist is arranged on the surface of the trench mask,
- in which a first etching is carried out to produce the trench to a first depth in the substrate (1), which attacks the substrate selectively on photoresist and the field-oxide region (2), so that the trench mask covered with photoresist and the part of the field-oxide region (2) laid bare act as an etching mask, a vertical substrate edge (8) being laid bare at the side of the trench (11) adjacent to the future source/drain region,
- in which a conformal Si₃N₄ layer (9) is deposited after removal of the photoresist,
- in which Si₃N₄ spacers (10) are formed from the conformal Si₃N₄ layer (9) at the vertical edges by anisotropic etching and the part of the field-oxide region laid bare is selectively etched away to form the trench mask,
- in which a second etching is carried out to a second depth in the substrate (1), the cross section of the trench (11) being defined by the trench mask and the depth of the trench (11) by the second depth,
- in which the surface of the trench (11) is provided with an SiO₂ layer (12),
- in which the Si₃N₄ spacers (10) are removed selectively with respect to SiO₂ and Si,
- in which the capacitor electrode (13) is produced in the trench (11) in such a way that it covers at least the vertical substrate edge (8) laid bare during the etching, and
- in which, on the side of the trench (11) which is remote from the field-oxide region (2), a source/drain region adjoining the capacitor electrode (13) is produced.

2. Process according to Claim 1, in which the field-oxide region (2) is produced in a LOCOS process.

3. Process according to Claim 1 or 2,
- in which, to produce the trench mask, a first SiO₂ layer (3), which is thinner than the field-oxide region (2), is deposited on the substrate (1) provided with the field-oxide region (2),
- in which an Si₃N₄ layer (4) is deposited on the first SiO₂ layer (3),
- in which a second SiO₂ layer (5) is deposited on the Si₃N₄ layer (4),
- in which a polysilicon layer (6) is deposited on the second SiO₂ layer (5),
- in which a photoresist mask (7) which defines the cross section of the trench parallel to the substrate surface is produced on the polysilicon layer (6),
- in which the polysilicon layer (6), the second SiO₂ layer (5), the Si₃N₄ layer (4) and the first SiO₂ layer (3) are each patterned in an anisotropic dry etching step using the photoresist mask (7) as etching mask so that the surface of the substrate (1) is laid bare to the side of the field-oxide region (2), and
- in which the photoresist mask (7) is removed after the first etching to produce the trench (11).

4. Process according to Claim 3, in which the first SiO₂ layer (3) is produced by thermal oxidation of the surface of the substrate (1) and in which the second SiO₂ layer (5) is produced by CVD deposition after decomposing Si(OC₂H₅)₄ (TEOS).

5. Process according to Claim 4, in which the first SiO₂ layer (3) is produced with a thickness of between 10 nm and 40 nm, the Si₃N₄ layer (4) with a thickness of between 20 nm and 60 nm, the second SiO₂ layer (5) with a thickness of between 200 nm and 1,000 nm and the polysilicon layer (6) with a thickness of between 20 nm and 100 nm.

6. Process according to one of Claims 1 to 5, in which the conformal Si₃N₄ layer (9) is deposited with a thickness of between 10 nm and 100 nm to form the Si₃N₄ spacers (10).

7. Process according to one of Claims 1 to 6, in which the Si₃N₄ spacers (10) are removed by wet-chemical etching.

8. Process according to one of Claims 1 to 7, in which the first depth assumes a value of between 30 nm and 300 nm and the second depth a value between 2 µm and 20 µm.

## Revendications

1. Procédé de réalisation d'un contact entre une électrode de condensateur disposée dans une tranchée et une zone source/drain d'un transistor MOS disposée hors de la tranchée,
- pour lequel dans un substrat (1), au moins une zone d'oxyde de champ (2) est formée sur le côté de la future zone source/drain pour isoler des zones actives voisines dans le substrat (1),
- pour lequel on produit un masque de tranchée qui définit l'emplacement de la tranchée sur le côté de la future zone source/drain sur le côté tourné vers la future zone source/drain de la zone d'oxyde de champ (2) de sorte que la tranchée est disposée entre la future zone source/drain et la zone d'oxyde de champ (2),
- pour lequel le masque de tranchée laisse partiellement découvert la zone d'oxyde de champ (2) sur le côté tourné vers la zone source/drain,
- pour lequel de la photolaque est disposée à la surface du masque de tranchée,
- pour lequel un premier gravage pour réaliser la tranchée a lieu à une première profondeur dans le substrat (1), attaquant le substrat de façon sélective par rapport à la photolaque et à la zone d'oxyde de champ (2) de sorte que le masque de tranchée revêtu de photolaque et la partie exposée de la zone d'oxyde de champ (2) font office de masque de gravure, en libérant un flanc de substrat vertical (8) sur le côté tourné vers la future zone source/drain de la tranchée (11),
- pour lequel une couche de Si₃N₄ conforme (9) est déposée après enlèvement de photolaque,
- pour lequel des entretoises de Si₃N₄ (10) sont formées par gravage anisotrope à partir d'une couche de Si₃N₄ conforme (9) sur les flancs verticaux et la partie exposée de la zone d'oxyde de champ est gravée de façon sélective par rapport au masque de gravage,
- pour lequel un deuxième gravage a lieu à une deuxième profondeur dans le substrat (1), la section de la tranchée (11) étant définie par le masque de tranchée et la profondeur de la tranchée (11) par la deuxième profondeur,
- pour lequel la surface de la tranchée (11) reçoit une couche de SiO₂ (12),
- pour lequel les entretoises de Si₃N₄ (10) sont enlevées de façon sélective par rapport au SiO₂ et au Si,
- pour lequel l'électrode de condensateur (13) dans la tranchée (11) est produite de telle sorte qu'elle recouvre au moins le flanc de substrat vertical (8) libéré par le gravage,
- pour lequel sur le côté opposé à la zone d'oxyde de champ (2) de la tranchée (11), on produit une zone source/drain limitrophe de l'électrode de condensateur (13).

2. Procédé selon la revendication 1,
pour lequel la zone d'oxyde de champ (2) est réalisée dans un procédé LOCOS.

3. Procédé selon la revendication 1 ou 2,
- pour lequel on dépose dans le but de réaliser le masque de tranchée, une première couche de SO₂ (3) sur le substrat (1) dotée de la zone d'oxyde de champ (2), cette couche étant plus fine que la zone d'oxyde de champ (2),
- pour lequel on dépose une couche de Si₃N₄ (4) sur la première couche de SiO₂(3),
- pour lequel on dépose une deuxième couche de SiO₂ (5) sur la couche de Si₃N₄ (4),
- pour lequel on dépose une couche de polysilicium (6) sur la couche de SiO₂ (5),
- pour lequel on réalise sur la couche de polysilicium (6) un masque en photolaque (7) qui définit la section de la tranchée parallèlement à la surface du substrat,
- pour lequel la couche de polysilicium (6), la deuxième couche de SiO₂ (5), la couche de Si₃N₄ (4) et la première couche de SiO₂ (3) sont respectivement structurées dans une phase de gravure à sec anisotrope en utilisant le masque de photolaque (7) comme masque de gravure de sorte que la surface du substrat (1) soit libérée sur le côté de la zone d'oxyde de champ (2),
- pour lequel le masque de photolaque (7) est enlevé après la première gravure pour réaliser la tranchée (11).

4. Procédé selon la revendication 3,
pour lequel on réalise la première couche de SiO₂ (3) par oxydation thermique de la surface du substrat (1) et pour laquelle la deuxième couche de SiO₂ (5) est réalisée par déposition chimique en phase vapeur (CVD) après décomposition du Si(OC₂H₅)₄ (TEOS).

5. Procédé selon la revendication 4,
pour lequel la première couche de SiO₂ (3) est réalisée dans une épaisseur variant entre 10 nm et 40 nm, la deuxième couche de Si₃N₄ (4) dans une épaisseur variant entre 20 nm et 60 nm, la deuxième couche de SiO₂ (5) dans une épaisseur de couche (5) variant entre 200 nm et 1000 nm et la couche de polysilicium (6) dans une épaisseur variant entre 20 nm et 100 nm.

6. Procédé selon les revendications 1 à 5,
pour lequel la couche de Si₃N₄ conforme (9) est déposée pour former les entretoises de Si₃N₄ (10) dans une épaisseur variant entre 10 nm et 100 nm.

7. Procédé selon les revendications 1 à 6,
pour lequel les entretoises de Si₃N₄ (10) sont enlevées par attaque chimique humide.

8. Procédé selon les revendications 1 à 7,
pour lequel la première profondeur atteint une valeur variant entre 30 nm et 300 nm et la deuxième profondeur, une valeur variant entre 2 µm et 20 µm.
